# EUROPÄISCHE PATENTSCHRIFT

(11) **EP 0 704 122 B1**
(45) Veröffentlichungstag und Bekanntmachung des Hinweises auf die Patenterteilung: **18.06.1997**
(21) Anmeldenummer: 94914366.3
(22) Anmeldetag: 13.04.1994
(51) Int. Cl.: H04L 5/06

(54) **VERFAHREN UND ANORDNUNG ZUR EINSSTELLUNG DER LOKALEN OSZILLATOREN EINES EMPFÄNGERS IN EINEM MEHRKANALÜBERTRAGUNGSSYSTEM**
PROCESS AND ARRANGEMENT FOR ADJUSTING THE LOCAL OSCILLATORS OF A RECEIVER IN A MULTI-CHANNEL TRANSMISSION SYSTEM
PROCEDE ET SYSTEME PERMETTANT DE REGLER LES OSCILLATEURS LOCAUX D'UN RECEPTEUR DANS UN SYSTEME DE TRANSMISSION A CANAUX MULTIPLES

(30) Priorität: 15.06.1993 DE 4319769
(43) Veröffentlichungstag der Anmeldung: 03.04.1996
(73) Patentinhaber: GRUNDIG Aktiengesellschaft, 90762 Fürth (DE)
(72) Erfinder: VANSELOW, Frank, D-91077 Dormitz (DE)
(86) Internationale Anmeldenummer: EP9401139
(87) Internationale Veröffentlichungsnummer: WO9429984

(56) Entgegenhaltungen:
- EP-A- 0 441 730
- EP-A- 0 441 731
- EP-A- 0 529 421
- WO-A-92/16063
- IEEE TRANSACTIONS ON COMMUNICATIONS, Bd.33, Nr.7, Juli 1985, NEW YORK US Seiten 665 - 675 L. J. CIMINI: 'Analysis and Simulation of a Digital Mobile Channel Using Orthogonal Frequency Division Multiplexing.'
- IEEE TRANSACTIONS ON VEHICULAR TECHNOLOGY, Bd.42, Nr.3, August 1993, NEW YORK US Seiten 302 - 313, XP000394042 W. D. WARNER / C. LEUNG: 'OFDM/FM Frame Synchronization for Mobile Radio Data Communication.'
- IEEE TRANSACTIONS ON COMMUNICATIONS, vol.33, Nr.7, July 1985, NEW YORK US Seiten 665 - 675 L. J. CIMINI: 'Analysis and Simulation of a Digital Mobile Channel Using Orthogonal Frequency Division Multiplexing.'
- IEEE TRANSACTIONS ON VEHICULAR TECHNOLOGY, vol.42, Nr.3, August 1993, NEW YORK US Seiten 302 - 313, XP000394042 W. D. WARNER / C. LEUNG: 'OFDM/FM Frame Synchronization for Mobile Radio Data Communication.'

## Beschreibung

Die Erfindung betrifft ein Verfahren und eine Anordnung zur Einstellung der lokalen Oszillatoren eines Empfängers in einem Mehrkanalübertragungssystem, bei welchem eine Grob- und eine Feinsynchronisation der Oszillatoren mittels im Empfänger bekannter Synchronsymbole erfolgt.

Mehrkanalübertragungssysteme werden u.a. bei der digitalen Übertragung von Rundfunksignalen, bekannt als DAB (Digital Audio Broadcast), verwendet. Bei dem dabei eingesetzten Mehrkanalübertragungssystem handelt es sich um das COFDM-Verfahren (Coded Orthogonal Frequency Division Multiplex). Aus der Veröffentlichung "Digitale Fernsehübertragung - Systemkonzepte und Einführungschancen" von R. Kays, erschienen in Fernseh- und Kino-Technik, Nr. 9/1992, Seiten 559 - 570, ist es darüber hinaus bekannt, daß die Verwendung von Mehrkanalübertragungssystemen, die auf OFDM- bzw. COFDM-Verfahren beruhen, auch für Realisierung eines digitalen terrestrischen Fernsehsystems möglich ist.

Bei einem Mehrkanalübertragungssystem zur digitalen Datenübertragung wird der zu übertragende Datenstrom auf eine Anzahl (mehrere hundert bis einige tausend) Unterträger aufgeteilt, die im Frequenzbereich nebeneinander liegen, wobei die Spektren der Unterträger sich auch überlappen können.
Durch diese Vorgehensweise wird mit jedem Unterträger eine um Größenordnungen niedrigere als die ursprüngliche Datenrate übertragen, wodurch die Symboldauer sich entsprechend vergrößert. Dies wirkt sich dann vorteilhaft aus, wenn auf dem Ubertragungskanal Echos entstehen. Durch geeignete Festlegung der Anzahl der Unterträger läßt sich ein Mehrkanalübertragungssystem stets so auslegen, daß die Symboldauer groß gegen die zu erwartende Echolaufzeit ist.

Der Einfluß von Echos mit bestimmter Laufzeit läßt sich ganz ausschalten, wenn die Symbole nicht unmittelbar aufeinanderfolgend gesendet werden, sondern wenn zwischen zwei aufeinanderfolgenden Symbolen jeweils eine Schutzzeit vorgesehen ist, in der die Echos des zuerst gesendeten Symbols abklingen.

Weitere Störeinwirkungen des Übertragungskanals lassen sich dadurch mindern, daß die zeitliche und/oder frequentielle Reihenfolge der zu übertragenden Informationen verwürfelt wird.

Die Modulation des Sendesignals in einem Mehrkanalübertragungssystem kann vorteilhaft mittels einer inversen schnellen Fourier-Transformation (IFFT) erfolgen, wobei sich die Zahl der zu transformierenden Werte aus der Anzahl der Unterträger ergibt. Das Mehrkanalmodulationssignal ist in Zeit-Frequenz-Schlitze aufgeteilt. Die Zeitschlitze werden durch den diskreten Symboltakt, die Frequenzschlitze durch den Frequenzabstand der Unterträger gebildet.
Die Demodulation des Mehrkanalmodulationssignals auf der Empfängerseite kann ebenso vorteilhaft mittels der schnellen Fourier-Transformation (FFT) erfolgen.

Eine nähere Beschreibung von Mehrkanalübertragungssystemen nach dem OFDM- bzw. COFDM-Verfahren findet sich beispielsweise in der Offenlegungsschrift WO 88/00417 oder der Veröffentlichung "Digital Sound Broadcasting to Mobile Receivers", IEEE Transactions on Consumer Electronics, Vol. 35, No. 3, August 1989, Seiten 493 - 503.

Die Datenübertragung bei Mehrkanalübertragungsverfahren nach dem OFDM-Verfahren erfolgt rahmenorientiert. Jeder Rahmen beginnt mit einem Nullsymbol, das zur Erkennung des Rahmenanfangs und zur zeitlichen Synchronisation dient. Danach folgen Synchronsymbole und die die Informationen tragenden Datensymbole.

Das OFDM-Verfahren erfordert, daß die Trägerfrequenzen von Sender und Empfänger sehr genau übereinstimmen. Die tolerierbare Abweichung wird durch den Frequenzabstand der Unterträger und die Komplexität der Modulation der einzelnen Unterträger bestimmt. Die Anforderungen steigen stark an, wenn die Modulation der Unterträger beispielsweise mit einer 64-QAM (Quadrature Amplitude Modulation) statt mit einer 4-PSK (Phase Shift Keying) erfolgt.

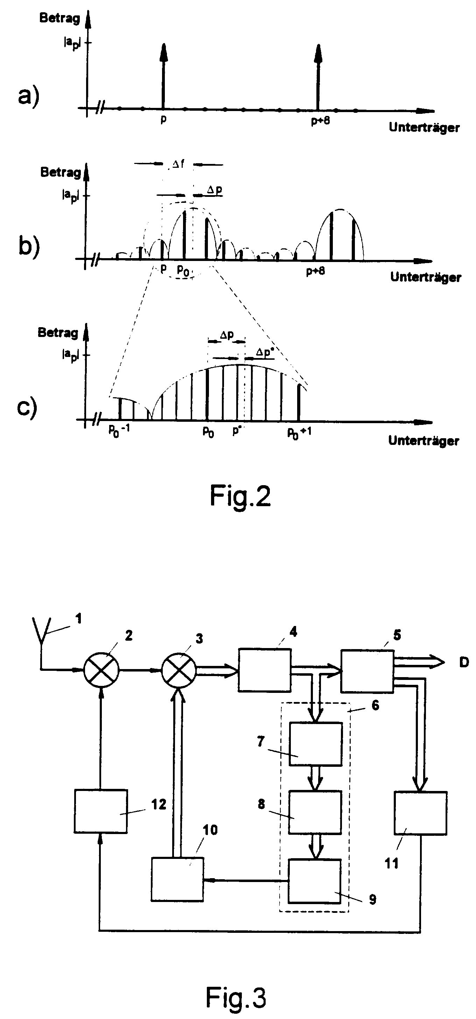

Durch Abweichungen der Trägerfrequenzen zwischen Sender und Empfänger entstehen nach der empfängerseitigen Fourier-Transformation Phasenstörungen, Amplitudenstörungen und Störungen durch Interferenzen, d.h. es entstehen zusätzliche spektrale Anteile. Figur 2a,b stellt diesen Zusammenhang dar.

Zur Steuerung der lokalen Oszillatoren des Empfängers und um empfängerseitige Abweichungen der Träger frequenzen auszugleichen, ist es beispielsweise aus der europäischen Offenlegungsschrift EP O 441 730 A1 bekannt, das oben bereits erwähnte Synchronsymbol zu verwenden. Das Synchronsymbol ist ein im Empfänger bekanntes Sendersymbol, das Unterträger nur an bestimmten Stellen innerhalb des Synchronsymbols aufweist. Die restlichen Unterträger sind unterdrückt. Beim Empfang des Synchronsymbols entstehen durch die beschriebenen Interferenzen neben einem Hauptspektralanteil, dessen Amplitude gegenüber dem ausgesendeten Unterträger gedämpft ist, zusätzliche spektrale Anteile. Durch Bestimmung des Hauptspektralanteils läßt sich die Abweichung der Trägerfrequenzen bestimmen und die lokalen Oszillatoren können entsprechend nachgesteuert werden.
Neben der Aussendung des Synchronsymbols am Rahmenanfang ist es auch möglich, das Symbol während des Rahmens zu wiederholen, um damit eine kontinuierlichere Steuerung der Oszillatoren zu ermöglichen.

Darüber hinaus ist es bekannt, daß durch Auswertung der nach der Fourier-Transformation vorhandenen, zusätzlichen spektralen Anteile im Abstand der Unterträger eine genauere Bestimmung der Abweichung der Trägerfrequenzen möglich ist. Dies wird durch eine Interpolation der zusätzlichen spektralen Anteile erreicht, die, wie in Figur 2b dargestellt, insgesamt den Verlauf einer Integralsinusfunktion beschreiben.

Aus der deutschen Offenlegungsschrift DE 41 28 713 A1 ist ein Verfahren und eine Anordnung zur Messung der Trägerfrequenzablage in einem Mehrkanalübertragungssystem bekannt, bei dem ein Synchronsymbol am Rahmenanfang verwendet wird, wobei die Frequenzablage mittels einer Korrelation bestimmt wird. Dabei wird in einem ersten Schritt eine grobe Messung der Frequenzabweichung in der Größenordnung des Unterträgerfrequenzabstandes durchgeführt. In einem zweiten Schritt wird eine Feinmessung durchgeführt, die auf den Bruchteil eines Unterträgerfrequenzabstandes genau ist. Aussagen über eine kontinuierliche Messung sind dem Dokument nicht zu entnehmen.

Als nachteilig ist bei den bekannten Verfahren anzusehen, daß die Bestimmung der Trägerfrequenzabweichung nicht beliebig präzise vorgenommen werden kann, was besonders bei zunehmender Komplexität der Trägermodulation wünschenswert ist. Darüber hinaus werden bei kleinen Abweichungen der Empfangsoszillatoren die zusätzlichen spektralen Anteile so klein, daß sie von Störungen verdeckt werden, wodurch eine exakte Synchronisation durch Interpolation des Verlaufs der Integralsinusfunktion unmöglich wird. Einen weiteren Nachteil stellt die Tatsache dar, daß für eine kontinuierlichere Bestimmung der Trägerfrequenzabweichung mehrere der bekannten

Synchronsymbole innerhalb eines Rahmens gesendet werden müssen, wodurch die insgesamt übertragbare Datenmenge verringert wird.

Aufgabe der vorliegenden Erfindung ist es deshalb, ein Verfahren und eine Anordnung zur Einstellung der lokalen Oszillatoren eines Empfängers in einem Mehrkanalübertragungssystem anzugeben, bei dem die aus dem Stand der Technik bekannten Nachteile vermieden werden.

Erfindungsgemäß wird diese Aufgabe durch die Merkmale der Ansprüche 1 und 6 gelöst.

Der Vorteil der Erfindung liegt insbesondere darin, daß eine kontinuierliche Einstellung der lokalen Oszillatoren des Empfängers möglich ist, deren Genauigkeit sich den Erfordernissen des jeweiligen Mehrkanalübertragungssystems dadurch anpassen läßt, daß die Anzahl der durch eine Fourier-Transformation zur Auswertung der Synchronsymbole zu bestimmenden Werte so festgelegt wird, daß mehr Werte bestimmt werden als Unterträger in einem bestimmten Frequenzbereich vorhanden sind.
Einen weiteren Vorteil stellt die Verwendung von speziellen Synchronsymbolen für die kontinuierliche Feinsynchronisation dar, wodurch eine bessere spektrale Ausnutzung des Übertragungskanals erreicht wird.

Weitere Ausgestaltungen und Vorteile der Erfindung ergeben sich aus den Unteransprüchen und der nachfolgenden Beschreibung der Erfindung anhand von Figuren.

Es zeigt:
Figur 1 die Darstellung eines beispielhaften Rahmens des dem erfindungsgemäßen Verfahren zugrundeliegenden Sendersignals in der Zeit-Frequenz-Ebene,
Figur 2 a) die Darstellung eines Ausschnitts eines beispielhaften Synchronsymbols im Frequenzbereich, b) die spektrale Darstellung des Ausschnitts des beispielhaften Synchronsymbols nach dem Empfang bei Vorliegen einer Trägerfrequenzabweichung im Empfänger, c) die spektrale Darstellung einer zur Feinsynchronisation verwendeten, sechsfach höheren Auflösung,
Figur 3 eine Ausführungsform eines erfindungsgemäßen Empfängers.

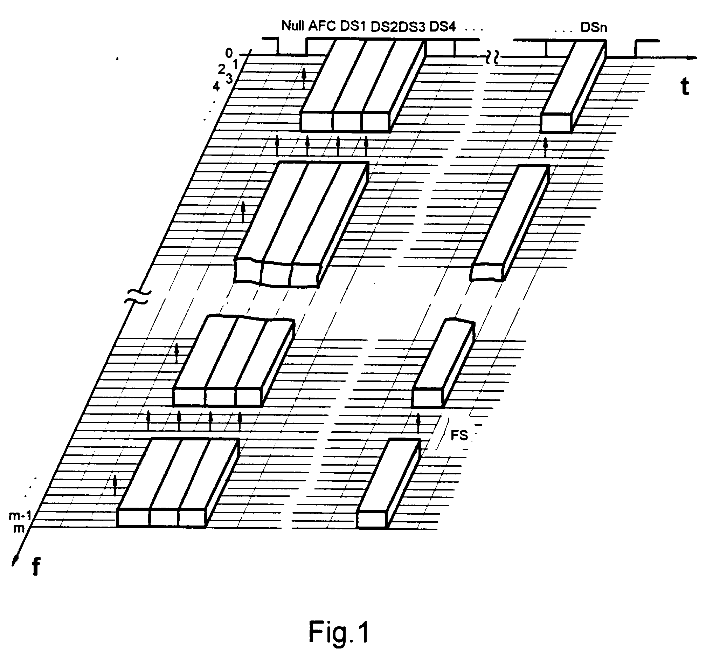

Der in Figur 1 in der Zeit-Frequenz-Ebene dargestellte beispielhafte Rahmen des Mehrkanalsignals weist zu Beginn ein Null-Symbol Null auf. Diesem folgt ein Synchronsymbol AFC sowie die Datensymbole DS1 bis DSn. Im dargestellten Beispiel wird das Signal auf m+1 Unterträger verteilt. Das Synchronsymbol AFC weist Unterträger mit konstanter Amplitude auf, die zueinander einen Abstand von jeweils acht Unterträgern aufweisen. Zwischen diesen liegende Unterträger sind unterdrückt. Durch die Wahl des Abstandes zwischen den Unterträgern konstanter Amplitude wird der Korrekturbereich festgelegt, innerhalb dessen Frequenzabweichungen der Empfangsoszillatoren ausgeglichen werden können. Im vorliegenden Beispiel beträgt dieser Korrekturbereich ± drei Unterträgerfrequenzabstände. Bei größeren Frequenzabweichungen kommt es zu einer Überlappung der oben beschriebenen zusätzlichen Spektralanteile, weshalb eine eindeutige Bestimmung der vorliegenden Frequenzabweichung nicht mehr möglich ist. Bei einer Vergrößerung der Abstände zwischen den nichtunterdrückten Unterträgern erhöht sich der Korrekturbereich entsprechend, beispielsweise auf ±15 Unterträgerfrequenzabstände bei einem Abstand von 32 Unterträgern.

Anhand des in Figur 2 dargestellten Ausschnitts aus dem Synchronsymbol AFC wird nachfolgend die erfindungsgemäße Synchronisation der lokalen Oszillatoren beschrieben.

Figur 2a stellt das vom Sender ausgestrahlte Synchronsymbol AFC dar. Da die genaue Lage der Unterträger im Synchronsymbol AFC als empfängerseitig bekannt vorausgesetzt wird, kann mittels des im Empfänger durch Fourier-Transformation erzeugten Spektrums die Einstellung der lokalen Oszillatoren erfolgen. Vorteilhaft wird die Schnelle-Fourier-Transformation (FFT) verwendet. Die Anzahl der Werte der Fourier-Transformation ist durch die Anzahl der Unterträger gegeben. Liegt keine Frequenzverschiebung zwischen den Unterträgerfrequenzen auf Sender- und Empfängerseite vor, so entspricht das im Empfänger erzeugte Spektrum dem Spektrum des ausgestrahlten Synchronsymbols AFC. Es treten nur an den bekannten Stellen Unterträger auf, eine Einstellung der lokalen Oszillatoren ist nicht nötig.

Figur 2b stellt das im Empfänger erzeugte Spektrum des Synchronsymbols AFC für den Fall einer Frequenzverschiebung Δf dar. Das Spektrum weist neben einem Hauptanteil an der Stelle p_{O} zusätzliche Anteile an den anderen Unterträgerpositionen auf. Zur Grobsynchronisation der lokalen Oszillatoren wird der spektrale Hauptanteil an der Stelle p_{O} ermittelt, indem der betragsmäßig größte Amplitudenwert bestimmt wird. Die bei der Grobsynchronisation erreichbare Genauigkeit liegt im Bereich eines halben Unterträgerfrequenzabstandes.

Nachdem die Grobsynchronisation der lokalen Oszillatoren erfolgt ist, wird ausgehend von der ermittelten Stelle p_{O} eine Feinsynchronisation durchgeführt, um die in Figur 2b dargestellte verbleibende Frequenzabweichung Δp zu verringern. Dazu wird, wie in Figur 2c gezeigt, die spektrale Auflösung erhöht. Die Erhöhung der spektralen Auflösung erfolgt erfindungsgemäß dadurch, daß zusätzlich eine Fourier-Transformation durchgeführt wird, bei der nur für den Frequenzbereich der weiteren Synchronsymbole FS mehr Werte berechnet werden als Unterträger vorhanden sind. Im gezeigten Beispiel nach Figur 2c wird die sechsfache Anzahl von Werten berechnet, und für den spektralen Hauptanteil wird die Stelle p* ermittelt. Die sich danach ergebende Frequenzabweichung Δp* ist entsprechend auf ein Sechstel verringert. Die Ermittlung der nachzuregelnden Frequenzabweichung erfolgt dabei ebenfalls durch Bestimmung des betragsmäßig größten Amplitudenwerts.

Um die gewünschte Genauigkeit der Feinsynchronisation zu erreichen wird die Anzahl der bei der zusätzlichen Fourier-Transformation berechneten Werte entsprechend erhöht.

Die zur Berechnung der zusätzlichen Fourier-Transformation benötigten Eingangswerte können am einfachsten durch "zero padding" erzeugt werden. Dabei werden für die Fourier-Transformation fehlende Werte zu null gesetzt. Eine nähere Beschreibung des "zero padding" findet sich beispielsweise in "Digitale Signalverarbeitung" von K. Kammeyer und K. Kroschel, erschienen im Teubner-Verlag Stuttgart, 1989.

Prinzipiell ist für die Feinsynchronisation die Auswertung nur eines der nichtunterdrückten Unterträger ausreichend. Zur Verringerung der Störanfälligkeit bietet es sich aber an, mehrere Unterträger innerhalb eines Synchronsymbols AFC entsprechend der beschriebenen Verfahrensweise auszuwerten und die Unterträgerfrequenzabweichung Δp* durch eine Mittelung der jeweils einzeln bestimmten Unterträgerfrequenzabweichungen zu ermitteln.

Um die Synchronisation der lokalen Oszillatoren nicht nur am Rahmenanfang mittels des Synchronsymbols AFC zu ermöglichen, werden in die Datensymbole weitere Synchronsymbole FS eingefügt. Dadurch wird eine kontinuierliche Feinsynchronisation ermöglicht. Die weiteren Synchronsymbole FS können eine wesentlich kleinere spektrale Breite als das Synchronsymbol AFC aufweisen, da durch die Grobsynchronisation bereits eine Verringerung der Frequenzabweichung auf einen halben Unterträgerfrequenzabstand erreicht wurde. Deshalb ist es nach dem oben bereits beschriebenen Zusammenhang ausreichend, wenn die weiteren Synchronsymbole FS aus einem Unterträger mit konstanter Amplitude, der von je zwei unterdrückten Unterträgern umgeben ist, gebildet werden. Für jedes der weiteren Synchronsymbole FS werden somit nur fünf Unterträger benötigt. Davon abweichende, größere Synchronsymbole FS sind möglich.

Zur Durchführung der erfindungsgemäßen Feinsynchronisation ist es ausreichend, eines der weiteren Synchronsymbole FS in jedes Datensymbol einzufügen. Zur Verringerung von Störeinflüssen ist es aber sinnvoll, mehrere Synchronsymbole FS in jedem Datensymbol vorzusehen (Figur 1) und, wie oben beschrieben, eine Mittelung durchzuführen.

Entsprechend der zeitlichen Anforderungen an die Kontinuität der Feinsynchronisation können die weiteren Synchronsymbole FS in jedem Datensymbol oder mit einem beliebigen Abstand von Datensymbolen eingefügt werden.

Figur 3 stellt eine erfindungsgemäße Ausführungsform eines Empfängers zur Durchführung des oben beschriebenen Verfahrens dar. Zur Vereinfachung sind nur erfindungswesentliche Bestandteile dargestellt.

Die über eine Antenne 1 empfangenen hochfrequenten Mehrkanalsignale werden mittels eines Mischers 2 sowie eines ersten lokalen Oszillators 12 in eine Zwischenfrequenzlage gebracht. Das Zwischenfrequenzsignal liegt an einem zweiten Mischer 3 an, an dessen zweitem Eingang ein zweiter lokaler Oszillator 10 anliegt. Die Mischer/Oszillator-Kombination 3, 10 führt eine komplexe Mischung des Zwischenfrequenzsignals durch. Nach dem Mischer 3 stehen zwei in Quadraturphasenbeziehung stehende Basisbandsignale zur Verfügung, welche in einem Analog/Digital-Wandler 4 digitalisiert werden.

Anschließend werden die Signale fourier-transformiert 5, wobei die Anzahl der zu bestimmenden Werte durch die Anzahl der das Mehrkanalsignal bildenden Unterträger festgelegt ist. Die günstigste Realisierungsform des Fourier-Transformators 5 stellt die Schnelle-Fourier-Transformation dar. Am Ausgang D des Fourier-Transformators 5 stehen die empfangenen Daten zur weiteren Verarbeitung zur Verfügung. Über den zweiten Ausgang wird das aus dem Synchronsymbol AFC gewonnene Signal zur Grobsynchronisation an der Einrichtung 11 zur Verfügung gestellt.

In der Einrichtung 11 werden die Amplituden des Signals ausgewertet und eine Maximumsuche wird durchgeführt, um den Hauptspektralanteil aufzufinden. Aus einem Vergleich der Lage des ermittelten Hauptspektralanteils mit dem bekannten Synchronsymbol AFC wird die vorliegende Frequenzabweichung der Unterträger bestimmt. Im Fall der Grobsynchronisation wird als Frequenzabweichung immer ein ganzzahliges Vielfaches des Unterträgerfrequenzabstandes ermittelt. Die Einrichtung zur Grobsynchronisation erzeugt auf Grundlage der beschriebenen Auswertung ein Regelsignal, mit welchem der lokale Oszillator 12 geregelt wird.

Zur Feinsynchronisation ist eine Einrichtung 6 vorhanden, welche die in den Latensymbolen vorhandenen weiteren Synchronsymbole FS auswertet. Dazu wird mittels eines Fourier-Transformators 7 eine Schnelle-Fourier-Transformation für den Frequenzbereich durchgeführt, den die weiteren Synchronsymbole FS einnehmen, bei der eine größere Anzahl von Werten berechnet wird, als insgesamt Unterträger im Mehrkanalsignal vorhanden sind. Die für jedes in einem Datensymbol vorhandene Synchronsymbol FS ermittelte Frequenzabweichung wird in einer Einrichtung 8 gemittelt. Anschließend erfolgt : einer Einrichtung 9 eine Maximumsbestimmung und die Erzeugung eines Regelsignals zur Feinsynchronisation des lokalen Oszillators 10. Bei der Feinsynchronisation werden Frequenzabweichungen ermittelt und ausgeregelt, die einem Bruchteil eines Unterträgerfrequenzabstandes entsprechen.

Für nachfolgende Rahmen wird mittels der Grobsynchronisation 11 die vorliegende Frequenzabweichung überprüft. Ist die festgestellte Abweichung geringer als ein Unterträgerfrequenzabstand wird der lokale Oszillator 12 nicht nachgeregelt. In diesem Fall kann das Synchronsymbol AFC auch zur Feinsynchronisation verwendet werden. Zur Steuerung dieser Wechselwirkung zwischen Grob- und Feinsynchronisation ist eine weitere Einrichtung vorhanden, die in Figur 3 nicht dargestellt ist. Außerdem ist nach dem Analog/Digital-Wandler 4 eine nicht dargestellte Einrichtung vorhanden, die der Normierung der Synchronsymbole dient. Diese Normierung ist nötig, weil die Amplituden der Unterträger in den Synchronsymbolen unterschiedliche Werte aufweisen, da das gesamte Mehrkanalsignal eine gleichmäßige spektrale Energieverteilung aufweisen soll. Diese wäre, bei gleichen Amplituden für alle nichtunterdrückten Unterträger, wegen der unterdrückten Unterträger in den Synchronsymbolen nicht gegeben.

Die beschriebene Aufteilung zur Regelung der Trägerfrequenzabweichung auf die beiden lokalen Oszillatoren ist besonders Vorteilhaft, da die Anforderungen an die Regelbarkeit der Oszillatoren gering sind. Andere Realisierungen sind jedoch ohne weiteres möglich.

## Patentansprüche

1. Verfahren zur Einstellung der lokalen Oszillatoren eines Empfängers in einem Mehrkanalübertragungssystem, bei welchem eine Grob- und eine Feinsynchronisation der Oszillatoren mittels im Empfänger bekannter Synchronsymbole erfolgt, wobei ein erstes Synchronsymbol (AFC) am Anfang eines jeden Rahmens sowie weitere Synchronsymbole (FS) innerhalb der nachfolgenden Datensymbole verwendet werden,
**dadurch gekennzeichnet,**
daß die weiteren Synchronsymbole (FS) eine geringere spektrale Breite aufweisen als das erste Synchronsymbol (AFC) und nur für die Feinsynchronisation verwendet werden, und
daß die Synchronsymbole (AFC;FS) zur Feinsynchronisation mit einer höheren spektralen Auflösung ausgewertet werden als zur Grobsynchronisation.

2. Verfahren nach Anspruch 1,
**dadurch gekennzeichnet,**
daß die weiteren Synchronsymbole (FS) einen Unterträger konstanter Amplitude aufweisen, und daß je zwei Unterträger vor und nach dem Unterträger konstanter Amplitude unterdrückt sind.

3. Verfahren nach Anspruch 1 oder 2,
**dadurch gekennzeichnet,**
daß bei Vorhandensein mehrerer weiterer Synchronsymbole (FS) in einem Datensymbol der Wert für die Feinsynchronisation durch eine Mittelung der einzelnen aus den jeweiligen weiteren Synchronsymbolen (FS) ermittelten Werte für die Feinsynchronisation gewonnen wird.

4. Verfahren nach einem der Ansprüche 1 bis 3,
bei dem die Synchronsymbole zur Auswertung fourier-transformiert werden, wobei die Anzahl der zu transformierenden Werte für die Grobsynchronisation gleich der Anzahl der im Mehrkanalübertragungssystem verwendeten Unterträger ist,
**dadurch gekennzeichnet,**
daß die höhere spektrale Auflösung für die Feinsynchronisation durch eine Fourier-Transformation erzielt wird, die im durch die weiteren Synchronsymbole (FS) belegten Frequenzbereich eine größere Anzahl von Werten berechnet als sie durch die Anzahl der Unterträger vorgegeben ist.

5. Verfahren nach Anspruch 4,
**dadurch gekennzeichnet,**
daß die größere Anzahl von Werten mittels "zero padding" berechnet wird.

6. Anordnung zur Einstellung der lokalen Oszillatoren eines Empfängers in einem Mehrkanalübertragungssystem, bei welchem eine Grob- und eine Feinsynchronisation der Oszillatoren mittels im Empfänger bekannter Synchronsymbole erfolgt, wobei ein erstes Synchronsymbol (AFC) am Anfang eines jeden Rahmens sowie weitere Synchronsymbole (FS) innerhalb der nachfolgenden Datensymbole verwendet werden, mit
- einem ersten lokalen Oszillator (12) und einem ersten Mischer (2) zur Erzeugung eines Zwischenfrequenzsignals aus einem Hochfrequenzsignal,
- einem zweiten lokalen Oszillator (10) und einem zweiten Mischer (3) zur Erzeugung zweier in Quadraturphasenbeziehung stehender Basisbandsignale,
- Analog-Digital-Wandlern (4) zur Digitalisierung der in
- Quadraturphasenbeziehung stehenden Signale, einer Einrichtung (5) zur Fourier-Transformation der digitalen Signale, bei der die Anzahl der Werte der Fourier-Transformation gleich der Anzahl der im Mehrkanalübertragungssystem verwendeten Unterträger ist, und
- einer Einrichtung (11) zur Grobsynchronisation wenigstens eines der lokalen Oszillatoren (12) nach Maßgabe der Auswertung des ersten Synchronsymbols,
**dadurch gekennzeichnet,**
daß eine Einrichtung (6) zur Feinsynchronisation vorhanden ist, die sowohl erste (AFC) als auch weitere Synchronsymbole (FS) auswertet, und
daß die Einrichtung zur Feinsynchronisation (6) einen Bestandteil (7) zur Fourier-Transformation der Synchronsymbole (AFC;FS) aufweist, wobei die Anzahl der Werte der Fourier-Transformation im Frequenzbereich der durch die weiteren Synchronsymbole (FS) belegt ist, größer als die Anzahl der Unterträger ist.

7. Anordnung nach Anspruch 6,
**dadurch gekennzeichnet,**
daß die Einrichtung (6) zur Feinsynchronisation einen Bestandteil (8) zur Mittelung der für die Feinsynchronisation bestimmten Werte aufweist.

8. Anordnung nach Anspruch 6 oder 7,
**dadurch gekennzeichnet,**
daß die Grobsynchronisation den ersten lokalen Oszillator (12) und die Feinsynchronisation den zweiten lokalen Oszillator (10) beeinflußt.

## Claims

1. Method for adjusting the local oscillators of a receiver in a multi-channel transmission system, in which a coarse synchronization and a fine synchronization of the oscillators takes place by means of synchronization symbols known in the receiver, a first synchronous symbol (AFC) at the start of each frame and further synchronous symbols (FS) being used within the subsequent data symbols, characterized in that the further synchronous symbols (FS) have a smaller spectral width than the first synchronous symbol (AFC) and are used only for the fine synchronization, and in that the synchronous symbols (AFC; FS) for the fine synchronization are evaluated with a higher spectral resolution than for the coarse synchronization.

2. Method according to Claim 1, characterized in that the further synchronous symbols (FS) have a constant-amplitude subcarrier and in that two subcarriers upstream and downstream of the constant-amplitude subcarrier are suppressed in each case.

3. Method according to Claim 1 or 2, characterized in that, if a plurality of further synchronous symbols (FS) is present in a data symbol, the value for the fine synchronization is determined by averaging the individual values for the fine synchronization determined from the respective further synchronous symbols (FS).

4. Method according to one of Claims 1 to 3, in which the synchronous symbols are Fourier-transformed for the evaluation, the number of values to be transformed for the coarse synchronization being equal to the number of subcarriers used in the multi-channel transmission system, characterized in that the higher spectral resolution for the fine synchronization is achieved by a Fourier transformation which calculates, in the frequency domain occupied by the further synchronous symbols (FS), a greater number of values than is given by the number of subcarriers.

5. Method according to Claim 4, characterized in that the greater number of values is calculated by means of "zero padding".

6. Arrangement for adjusting the local oscillators of a receiver in a multi-channel transmission system in which a coarse synchronization and a fine synchronization of the oscillators takes place by means of synchronous symbols known in the receiver, a first synchronous symbol (AFC) being used at the start of each frame and further synchronous symbols (FS) being used within the subsequent data symbols, comprising
- a first local oscillator (12) and a first mixer (2) for generating an intermediate frequency signal from a high-frequency signal,
- a second local oscillator (10) and a second mixer (3) for generating two baseband signals which are in quadrature phase relationship,
- analog/digital converters (4) for digitizing the signals which are in quadrature phase relationship,
- a device (5) for the Fourier transformation of the digital signals, in which the number of values of the Fourier transformation is equal to the number of subcarriers used in the multi-channel transmission system, and
- a device (11) for the coarse synchronization of at least one of the local oscillators (12) in accordance with the evaluation of the first synchronous symbol,
characterized in that a device (6) for the fine synchronization is present which evaluates both first (AFC) and further synchronous symbols (FS),
in that the device for the fine synchronization (6) has a component (6) for the Fourier transformation of the synchronous symbols (AFC; FS), the number of values of the Fourier transformation in the frequency domain occupied by the further synchronous symbols (FS) being greater than the number of subcarriers.

7. Arrangement according to Claim 6, characterized in that the device (6) for the fine synchronization has a component (8) for averaging the values determined for the fine synchronization.

8. Arrangement according to Claim 6 or 7, characterized in that the coarse synchronization influences the first local oscillator (12) and the fine synchronization influences the second local oscillator (10).

## Revendications

1. Procédé pour régler les oscillateurs locaux d'un récepteur d'un système de transmission à canaux multiples, dans lequel une synchronisation approximative et une synchronisation précise des oscillateurs sont effectuées à l'aide de symboles de synchronisation connus dans le récepteur, selon lequel un premier symbole de synchronisation (AFC) est utilisé au début de chaque trame et d'autres symboles de synchronisation (FS) sont utilisés à l'intérieur des symboles suivants de données, caractérisé en ce
que les autres symboles de synchronisation (FS) possèdent une largeur spectrale inférieure à celle du premier symbole de synchronisation (AFC) et sont utilisés uniquement pour la synchronisation précise, et
que les symboles de synchronisation (AFC; FS) pour la synchronisation précise sont évalués avec une résolution spectrale supérieure à celle prévue pour la synchronisation approximative.

2. Procédé selon la revendication 1, caractérisé en ce que les autres symboles de synchronisation (FS) possèdent une sous-porteuse d'amplitude constante et que respectivement deux sous-porteuses avant et après la sous-porteuse d'amplitude constante sont supprimées.

3. Procédé selon la revendication 1 ou 2, caractérisé en ce que dans le cas de la présence de plusieurs autres symboles de synchronisation (FS) dans un symbole de données, la valeur pour la synchronisation précise est obtenue par formation de la moyenne des différentes valeurs, déterminées à partir des autres symboles respectifs de synchronisation (FS), pour la synchronisation précise.

4. Procédé selon l'une des revendications 1 à 3, selon lequel les symboles de synchronisation sont transformés selon une transformation de Fourier pour leur exploitation, le nombre des valeurs à transformer pour la synchronisation approximative étant égal au nombre des sous-porteuses utilisées dans le système de transmission à canaux multiples, caractérisé en ce que la résolution spectrale supérieure pour la synchronisation précise est obtenue au moyen d'une transformation de Fourier, qui dans la gamme de fréquences occupée par les autres symboles de synchronisation (FS) calcule un nombre de valeurs plus important que celui prédéterminé par le nombre des sous-porteuses.

5. Procédé selon la revendication 4, caractérisé en ce que le nombre supérieur de valeurs est calculé au moyen d'un "zero padding".

6. Dispositif pour régler les oscillateurs locaux d'un récepteur d'un système de transmission à canaux multiples, dans lequel une synchronisation approximative et une synchronisation précise des oscillateurs sont effectuées à l'aide de symboles de synchronisation connus dans le récepteur et dans lequel un premier symbole de synchronisation (AFC) est utilisé au début de chaque trame et d'autres symboles de synchronisation (FS) sont utilisés à l'intérieur des symboles suivants de données, comportant
- un premier oscillateur local (12) et un premier mélangeur (2) pour produire un signal à fréquence intermédiaire à partir d'un signal à haute fréquence,
- un second oscillateur local (10) et un second mélangeur (3) pour produire deux signaux dans la bande de base, qui sont dans une relation de phase en quadrature,
- des convertisseurs analogique / numérique (4) pour numériser les signaux, qui sont dans une relation de quadrature de phase, un dispositif (5) pour la transformation de Fourier des signaux numériques, dans lequel le nombre des valeurs de la transformation de Fourier est égal au nombre des sous-porteuses utilisées dans le système de transmission à canaux multiples, et
- un dispositif (11) pour réaliser la synchronisation approximative d'au moins l'un des oscillateurs locaux (12) en fonction de l'exploitation du premier symbole de synchronisation,
caractérisé en ce qu'il est prévu un dispositif (6) pour réaliser la synchronisation précise, qui exploite aussi bien des premiers symboles de synchronisation (AFC) que d'autres symboles de synchronisation (FS), et
que le dispositif de synchronisation précise (6) possède un composant (7) pour réaliser la transformation de Fourier des symboles de synchronisation (AFC; FS), le nombre des valeurs de la transformation de Fourier dans la gamme de fréquences, qui est occupée par les autres symboles de synchronisation (FS), étant supérieur au nombre des sous-porteuses.

7. Dispositif selon la revendication 6, caractérisé en ce que le dispositif (6) pour la synchronisation précise possède un composant (8) servant à former la moyenne des valeurs déterminées pour la synchronisation précise.

8. Dispositif selon la revendication 6 ou 7, caractérisé en ce que la synchronisation approximative influe sur le premier oscillateur local (12), et la synchronisation précise influe sur le second oscillateur local (10).
